# EUROPEAN PATENT APPLICATION

(11) **EP 2 903 033 A1**
(43) Date of publication of application: **05.08.2015**
(21) Application number: 13841704.3
(22) Date of filing: 03.09.2013
(51) Int. Cl.: H01L 31/04

(54) **SOLAR CELL MODULE**

(30) Priority: 27.09.2012 JP 2012214511
(71) Applicant: Sanyo Electric Co., Ltd., Moriguchi-city, Osaka 570-8677 (JP)
(72) Inventor: MAKI, Kenichi, Moriguchi City Osaka 570-8677 (JP); KANEKO, Tetsuya, Moriguchi City Osaka 570-8677 (JP)
(74) Representative: Glawe, Delfs, Moll
(86) International application number: PCT/JP2013/073634
(87) International publication number: WO 2014/050451

(57) **Abstract**

A solar cell module wherein fluctuations of output characteristics are unlikely to occur is provided. This solar cell module includes a solar cell, a first protective member provided on an outer side of the solar cell when viewed from the moving body, a second protective member provided on an inner side of the solar cell when viewed from the moving body, and a metal layer provided inward of the solar cell when viewed from the moving body. The metal layer is insulated from the solar cell and is electrically connected to ground potential.

## Description

### TECHNICAL FIELD

The invention relates to a solar cell module.

### BACKGROUND ART

A concept of installing a solar cell module in a vehicle has heretofore been proposed as disclosed in Patent Document 1 and the like.

### PRIOR ART DOCUMENT

### PATENT DOCUMENT

Patent Document 1: Japanese Patent Application Publication No. 2012-033573

### SUMMARY OF THE INVENTION

### PROBLEM TO BE SOLVED BY THE INVENTION

When a solar cell module is installed in a vehicle, an output characteristic of the solar cell module may fluctuate.

A main object of the invention is to provide a solar cell module that is less likely to cause a fluctuation in its output characteristic.

### MEANS FOR SOLVING THE PROBLEM

A solar cell module of the invention is a solar cell module to be attached to a moving body. The solar cell module of the invention includes a solar cell, a first protective member, a second protective member, and a metal layer. The first protective member is provided on an outer side of the solar cell when viewed from the moving body. The second protective member is provided on an inner side of the solar cell when viewed from the moving body. The metal layer is provided on the inner side the solar cell when viewed from the moving body. The metal layer is insulated from the solar cell and is connected to ground potential.

### EFFECTS OF THE INVENTION

The invention can provide a solar cell module that is less likely to cause a fluctuation in its output characteristic.

### BRIEF DESCRIPTION OF THE DRAWINGS

[Fig. 1] Fig. 1 is a schematic cross-sectional view of a moving body in a first embodiment.
[Fig. 2] Fig. 2 is a schematic cross-sectional view of a solar cell module in the first embodiment.
[Fig. 3] Fig. 3 is a schematic cross-sectional view of a solar cell module in a modified example.
[Fig. 4] Fig. 4 is a schematic cross-sectional view of a solar cell module in a second embodiment.

### MODES FOR CARRYING OUT THE INVENTION

Examples of preferred embodiments to carry out the invention are described below. It is to be noted, however, that the following embodiments are mere examples. The invention is not in any way limited to the following embodiments.

Moreover, in the drawings referred to in the embodiments and the like, components having substantially the same functions are denoted by the same reference numerals. In addition, the drawings referred to in the embodiments and the like are schematically illustrated. Accordingly, dimensional ratios and the like of objects depicted in the drawings may differ from actual dimensional ratios and the like of the objects. Such dimensional ratios and the like of the objects may also differ between the drawings. Therefore, the specific dimensional ratios and the like of the objects are to be determined in consideration of the following description.

### (First Embodiment)

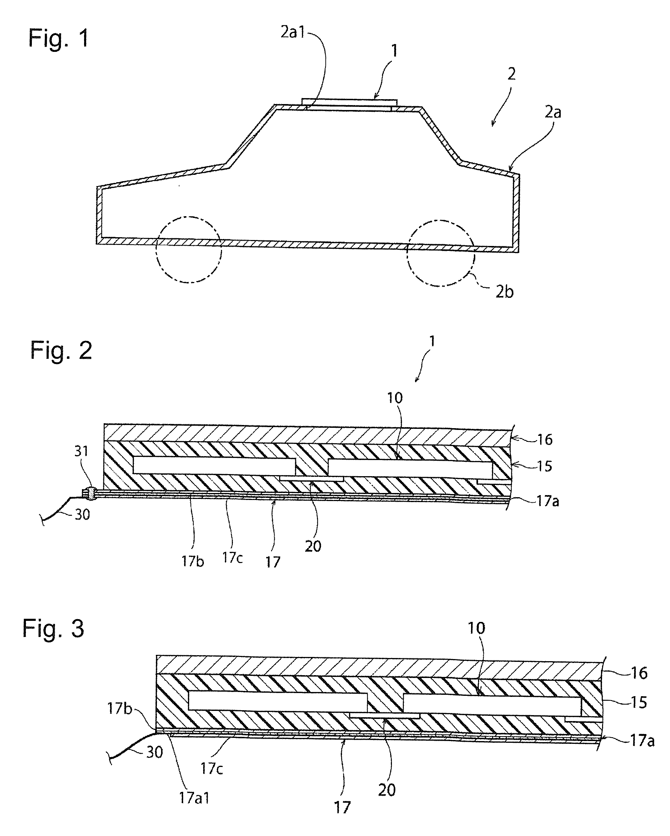

As illustrated in Fig. 1, solar cell module 1 is used by being attached to moving body 2. For example, moving body 2 may be an automobile, an electric train, and the like. This embodiment explains an example in which moving body 2 is constructed as an automobile.

Moving body 2 includes vehicle body 2a and wheels 2b. Vehicle body 2a is mainly made of metal plates. Vehicle body 2a is provided with opening 2a1. Opening 2a1 may constitute a sun roof provided in the ceiling, for example. Solar cell module 1 is attached to opening 2a1. Here, opening 2a1 may be covered up with solar cell module 1. Alternatively, opening 2a1 may be covered up with a window plate made of a material other than a metal, such as glass, and solar cell module 1 may be attached to the window plate.

As illustrated in Fig. 2, solar cell module 1 includes solar cells 10. Specifically, solar cell module 1 includes solar cells 10 that electrically connect to one another through wiring members 20. However, the invention is not limited only to this configuration. For example, a solar cell module may include one solar cell. In the meantime, such a solar cell may be a back contact solar cell in which first and second electrodes are provided on one surface side, or may be a solar cell in which a first electrode is provided on one surface side while a second electrode is provided on another surface side.

First protective member 16 is provided on one side of solar cells 10 while second protective member 17 is provided on another side thereof. Specifically, first protective member 16 is provided on an outer side of solar cells 10 when viewed from the vehicle, and second protective member 17 is provided on an inner side of solar cells 10 when viewed the vehicle. Sealant 15 is provided between first protective member 16 and second protective member 17. Solar cells 10 are sealed by sealant 15. First protective member 16 can be made of a glass plate, a ceramic plate, a resin plate or the like. Sealant 15 can be made of a non-crosslinked resin such as ethylene vinyl acetate copolymer (EVA), a non-crosslinked resin such as polyolefin, and the like.

Second protective member 17 adopts a three-layered structure, in which metal layer 17a is included between first resin layer 17b and second resin layer 17c. First resin layer 17b and second resin layer 17c can be each made of, for example, a fluorine-based resin film such as a polyvinyl fluoride film, a polyester film such as polyethylene terephthalate (PET) film, and the like. Metal layer 17a can be made of, for example, aluminum, an aluminum alloy, and the like. Metal layer 17a may be provided in a sheet fashion or provided in a mesh fashion. In other words, metal layer 17a may include openings. Metal layer 17a may be provided on the outside of a resin sheet.

Metal layer 17a is connected to ground potential. Specifically, as illustrated in Fig. 2, second protective member 17 extends outward from other components at least at a portion on an end of solar cell module 1, and fitting 31 that penetrates second protective member 17 is attached to this extension portion. In other words, fitting 31 contacts and electrically connected to metal layer 17a. Fitting 31 connects to vehicle body 2a as illustrated in Fig. 1 with an earth wire 30, which is schematically illustrated in Fig. 2. Thus, metal layer 17a is connected to the ground potential via vehicle body 2a and wheels 2b. Here, earth wire 30 may be connected directly to metal layer 17a without using fitting 31. Fitting 31 may be connected directly to vehicle body 2a without using earth wire 30. Alternatively, as illustrated in Fig. 3, metal layer 17a extends outward from at least any of first resin layer 17b and second resin layer 17c at least at a portion on an end of solar cell module 1, and is thus exposed from first and second resin layers 17b, 17c. Exposed portion 17a1 of metal layer 17a from first and second resin layers 17b, 17c may be connected to vehicle body 2a either directly or via earth wire 30.

In general, devices including motors and electronic devices, which radiate electromagnetic waves, are provided inside the moving body. Accordingly, when the solar cell module is provided in the moving body, the solar cell module is exposed to the electromagnetic waves from the devices installed in the moving body. If the solar cell module is exposed to the electromagnetic waves, an output from the solar cell module may contain noise attributed to the electromagnetic waves, whereby its output characteristic may fluctuate.

Here, in solar cell module 1, second protective member 17 includes metal layer 17a, and metal layer 17a is connected to the ground potential. For this reason, metal layer 17a shields the electromagnetic waves from the inside of the vehicle, thereby inhibiting the electromagnetic waves radiated inside of the vehicle from reaching solar cells 10. Thus, occurrence of the fluctuation in output characteristic attributed to the electromagnetic waves is suppressed, whereby a stable output characteristic is realized.

### (Second Embodiment)

The first embodiment describes the example in which metal layer 17a is provided inside second protective member 17. However, the location of the metal layer in the invention is not particularly limited as long as the metal layer is provided on the inner side of the solar cells when viewed from the vehicle (on the second protective member side). Nonetheless, the metal layer and each solar cell have to be electrically insulated from each other.

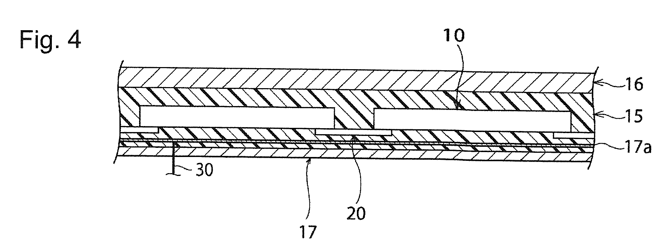

As illustrated in Fig. 4, metal layer 17a may be provided between solar cells 10 and second protective member 17, and inside sealant 15 that is provided between first protective member 16 and second protective member 17. Here, sealant 15 is provided between metal layer 17a and solar cells 10. Since sealant 15 is made of a resin, metal layer 17a and each solar cell 10 are insulated from each other. Alternatively, metal layer 17a may be provided at a boundary between second protective member 17 and sealant 15. An effect substantially the same as that of the first embodiment can also be obtained in these cases.

### EXPLANATION OF REFERENCE NUMERALS

- 1: solar cell module
- 2: moving body
- 10: solar cell
- 15: sealant
- 16: first protective member
- 17: second protective member
- 17a: metal layer
- 17a1: exposed portion
- 30: earth wire

## Claims

1. A solar cell module to installed in a moving body, comprising:
a solar cell;
a first protective member provided on an outer side of the solar cell when viewed from the moving body;
a second protective member provided on an inner side of the solar cell when viewed from the moving body; and
a metal layer provided inward of the solar cell when viewed from the moving body, wherein
the metal layer is insulated from the solar cell and is electrically connected to ground potential.

2. The solar cell module according to claim 1, wherein the solar cell module is attached to an opening of the moving body.

3. The solar cell module according to claim 1 or 2, wherein
the second protective member includes:
a first resin layer facing the solar cell;
a second resin layer facing inside of the moving body;
and the metal layer provided between the first resin layer and the second resin layer.

4. The solar cell module according to any one of claims 1 to 3, further comprising:
a sealant provided between the solar cell and the second protective member, wherein
the metal layer is provided inside the sealant.

5. The solar cell module according to any one of claims 1 to 4, wherein the metal layer is connected to the ground potential by an earth wire connection to the moving body.

6. The solar cell module according to claim 3, wherein
the metal layer includes an exposed portion exposed to at least one of the first resin layer and the second resin layer, and the metal layer is connected to the ground potential by connection of the exposed portion to the moving body.

7. The solar cell module according to any one of claims 1 to 6, wherein the moving body is an automobile.
